Europäisches Patentamt

European Patent Office

Office européen des brevets

(19)

(11) Publication number: **0 057 556**
**B1**

(12) **EUROPEAN PATENT SPECIFICATION**

(45) Date of publication of patent specification: **10.08.88**

(51) Int. Cl.⁴: **G 11 C 11/40**

(21) Application number: **82300381.9**

(22) Date of filing: **26.01.82**

(54) **Static semiconductor memory device.**

(30) Priority: **29.01.81 JP 11972/81**

(43) Date of publication of application:
**11.08.82 Bulletin 82/32**

(45) Publication of the grant of the patent:
**10.08.88 Bulletin 88/32**

(84) Designated Contracting States:
**DE FR GB NL**

(56) References cited:
**DE-B-2 744 490**
**US-A-3 745 540**

**IEEE JOURNAL OF SOLID-STATE CIRCUITS,
vol. SC-13, no. 5, October 1978, pages 556-663,
IEEE, New York, US; K. KAWARADA et al.: "A
fast 7.5 ns access 1K-bit RAM for cache-
memory systems"**

(73) Proprietor: **FUJITSU LIMITED
1015, Kamikodanaka Nakahara-ku
Kawasaki-shi Kanagawa 211 (JP)**

(72) Inventor: **Isogai, Hideaki
11-13, Minamisawa 4-chome
Higashikurume-shi Tokyo 180-03 (JP)**

(74) Representative: **Abbott, Leonard Charles et al
GILL JENNINGS & EVERY 53-64 Chancery Lane
London WC2A 1HN (GB)**

## Description

The present invention relates to a static semiconductor memory device in which erroneous writing in cells is prevented.

In bipolar type static RAM (random access memory), memory cells are arranged at intersections of words lines and pairs of bit lines. Each memory cell is formed by a flip-flop circuit including a pair of multiemitter transistors, load resistors, and Schottky barrier diodes connected to the load resistors in parallel.

Recent increases in the capacity of static RAM's have led to increases in the resistance value of the load resistors. In conventional static RAM, however, a problem arises in case that, for example, a memory cell $M_{11}$ is selected by selecting a word line $W_1$ and a column $B_1$ soon after a memory cell $M_{00}$ is selected by selecting a word line $W_0$ and a column $B_0$. In such a case, a memory cell $M_{01}$ connected to the word line $W_0$ and column $B_1$ is temporarily selected before the intended memory cell $M_{11}$ is selected. This is because a column selection is generally faster than a word line selection. In such conventional static RAM, there is a possibility of erroneous writing in the selected cell $M_{11}$ as is explained below.

An object of the present invention is to provide a static semiconductor memory device in which erroneous writing in cells is prevented. The paper by Kawarda et al. in IEEE J. Solid State Physics Vol. SC-13, No. 5, Oct. 1978 at pp. 656—663 discloses a static semiconductor memory device including static memory cells respectively connected to a pair of word lines and a pair of bit lines, the static semiconductor memory device comprising a pair of unidirectional current elements and a constant current source, each unidirectional current element being connected at one end so as to absorb electric current from a respective bit line of the pair of bit lines.

According to the present invention such a device is characterised in that the other end of each undirectional current element is connected to the constant current source via a switching means, the switching means being switched ON by a column-selecting voltage only when the column-selecting voltage is at a level such that a respective column is selected.

Further features and advantages of the present invention will be apparent from the ensuing description of known static RAMs and of some preferred embodiments of the invention, with reference to the accompanying drawings wherein:—

Figure 1 is a block diagram of a conventional static RAM;

Figure 2 is a circuit of memory cells included in the RAM shown in Figure 1;

Figure 3 is a waveform timing chart showing changes of potentials at the respective parts of the memory device shown in Figures 1 and 2;

Figure 4 is a block diagram of one embodiment of a static semiconductor memory cell according to the present invention; and

Figure 5 is a block diagram of another embodiment of the static semiconductor memory cell according to the present invention.

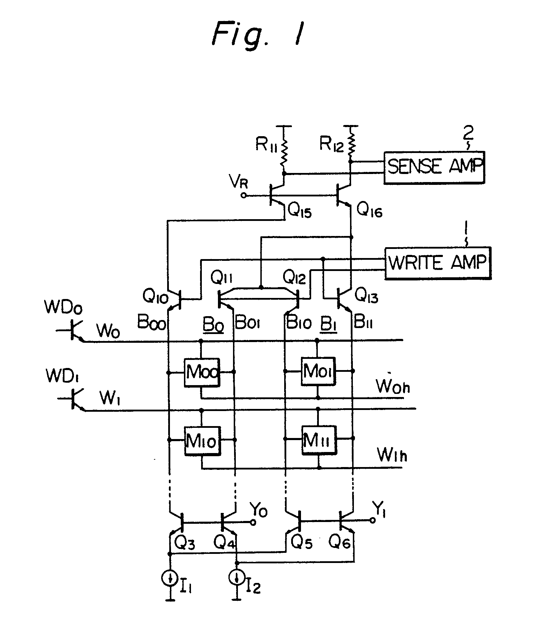

A conventional bipolar type static RAM comprises a plurality of memory cells $M_{00}$, $M_{01}$, ... arranged at intersections of word lines $W_0$, $W_1$, ... and pairs of bit lines $B_{00}$, $B_{01}$, $B_{10}$, and $B_{11}$, ... as shown in Figure 1. In Figure 1, $W_{0h}$, $W_{1h}$, ... represent negative side word lines or hold lines; $WD_0$, $WD_1$, ... represent word drivers; $Q_3$ and $Q_4$ and $Q_5$ and $Q_6$ represent column-selecting transistors; $Y_0$, $Y_1$, ... represent column-selecting voltages; and I1 and I2 represent constant current sources. The pairs of bit lines $B_{00}$ and $B_{01}$, $B_{10}$ and $B_{11}$, ..., are connected to emitters of bit drivers $Q_{10}$, $Q_{11}$, $Q_{12}$, $Q_{13}$. Bases of the bit drivers $Q_{10}$, $Q_{11}$, $Q_{12}$ and $Q_{13}$ are connected to a write amplifier 1, and collectors of the bit drivers $Q_{10}$, $Q_{11}$, $Q_{12}$, and $Q_{13}$ are connected via transistors $Q_{15}$ and $Q_{16}$ to a sense amplifier 2. Bases of the transistors $Q_{15}$ and $Q_{16}$ receive a reference voltage $V_R$, and collectors of the transistors $Q_{15}$ and $Q_{16}$ are connected via load resistor $R_{11}$ and $R_{12}$ to electric sources.

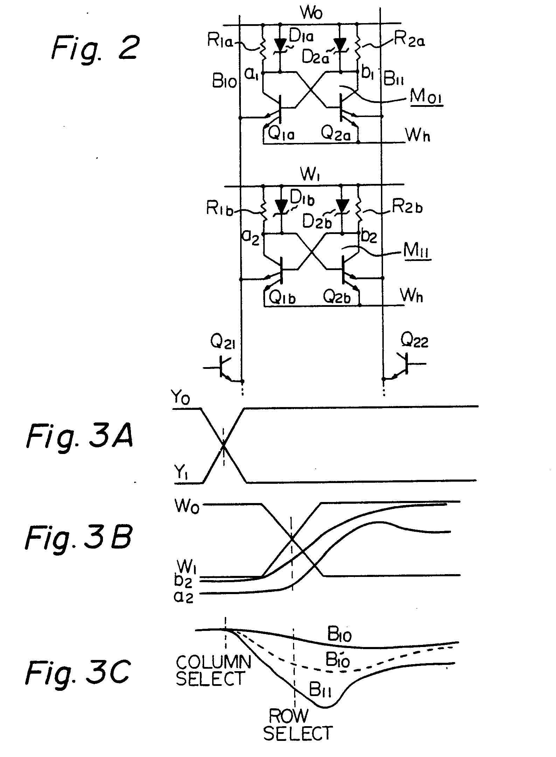

Fig. 2 shows the detailed circuit of memory cells $M_{01}$ and $M_{11}$ shown in Fig. 1. As shown in Fig. 2, memory cells $M_{01}$, $M_{11}$ are formed by flip-flop circuits, each including load resistors $R_{1a}$, $R_{2a}$; $R_{1b}$, $R_{2b}$, Schottky barrier diodes $D_{1a}$, $D_{2a}$; $D_{1b}$, $D_{2b}$, and multiemitter transistors $Q_{1a}$, $Q_{2a}$; $Q_{1b}$, $Q_{2b}$.

In the static RAM shown in Figs. 1 and 2, a problem arises in case that, for example, a memory cell $M_{11}$ is selected by selecting a word line $W_1$ and a column $B_1$ soon after a memory cell $M_{00}$ is selected by selecting a word line $W_0$ and a column $B_0$. In such a case, a memory cell $M_{01}$ connected to the word line $W_0$ and the column $B_1$ is temporarily selected before the intended memory cell $M_{11}$ is selected. This is because of that a column selection is generally faster than a word line selection. In such conventional static RAM, there is a possibility of erroneous writing in the selected cell $M_{11}$ as is explained below.

That is, suppose the write data is supplied so that, in each of the memory cells $M_{01}$ and $M_{11}$, the transistors $Q_{1a}$, $Q_{1b}$, on the left side in Fig. 2, are turned on and the transistors $Q_{2a}$, $Q_{2b}$, on the right side in Fig. 2, are turned off. A high (H) voltage level then is maintained at the points $b_1$, $b_2$ in the cell, and a low (L) voltage level then is maintained at the points $a_1$, $a_2$ in the cell. Since the transistors $Q_{1a}$, $Q_{1b}$ are in the "on" state, their collector currents flow to the high resistors $R_{1a}$, $R_{1b}$. Significant voltage drop across the resistors $R_{1a}$ and $R_{1b}$ turns on the Schottky barrier diodes $D_{1a}$, $D_{1b}$. On the other hand, since the transistors $Q_{2a}$, $Q_{2b}$ are in the "off" state, their collector currents do not flow through the high resistors $R_{2a}$, $R_{2b}$ and, therefore, the Schottky barrier diodes $D_{2a}$, $D_{2b}$ are in the off state. Accordingly, the impedance between the word lines $W_0$, $W_1$ and the points $a_1$, $a_2$ is low while the impedance between the word lines and the points $b_1$, $b_2$ is high. Therefore, when the row $W_1$ is selected, the potential at the point $a_2$ in the memory cell $M_{11}$ rises faster than that at the point $b_2$ in the memory cell $M_{11}$ as

shown in Fig. 3B. Before the column is selected, both the bit lines $B_{10}$ and $B_{11}$ are clamped at a high voltage by clamp circuits $Q_{21}$ and $Q_{22}$, but selection of the column releases this clamping. Since the selecting speed on column is faster than that on the word line, as shown in Figs. 3A and 3B, the potential of the bit line $B_{10}$ is clamped by the memory cell $M_{01}$ and is maintained at a high level, while the potential of the bit line $B_{11}$ is maintained at a low level as shown in Fig. 3C determined by the base potential of the transistor $Q_{13}$ (Fig. 1), whereby not the word line $W_0$ but the word line $W_1$ is selected. However, the potential of the bit line $B_{10}$ is still kept high because of a capacitance attached to the bit line, and the potential of the bit line $B_{11}$ is maintained at a low level determined by the transistor $Q_{13}$. In this circumstance, the potential difference between the point $a_2$ and the bit line $B_{10}$ is kept in the low bias voltage state, and the potential difference between the point $b_2$ and the bit line $B_{11}$ is kept in the high bias voltage state. Therefore in the case where the above difference resides between the bit lines $B_{10}$ and $B_{11}$, during the selection of the memory cell $M_{11}$ from the side of the word line $W_1$, the bit line $B_{10}$ is at a high level and the bit line $B_{11}$ is at a low level. Therefore, there is a possibility that the transistor $Q_{1b}$ may be turned off and the transistor $Q_{2b}$ may be turned on in the selected cell $M_{11}$.

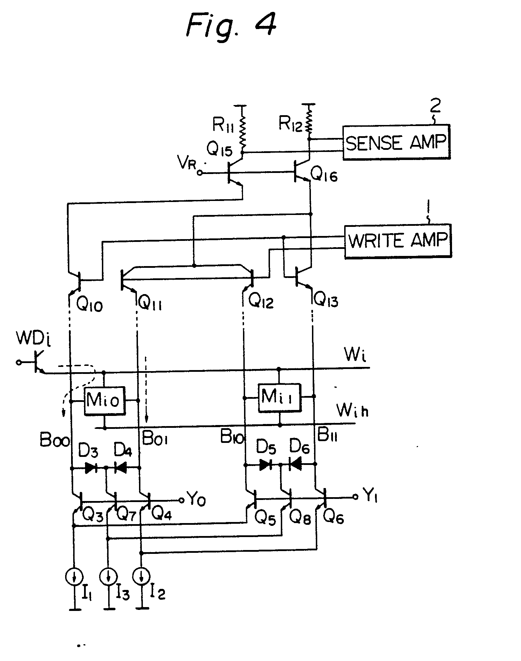

The present invention is meant to solve this problem. Fig. 4 is the block diagram of one embodiment of the present invention. In Fig. 4, $M_{10}$ and $M_{11}$ repesent a memory cell place at i row and 0 column and a memory cell placed at i row and 1 column, respectively. Each memory cell has the same structure as that of the above-mentioned memory cells $M_{01}$, $M_{11}$ etc. $W_i$ designates a word line of row i, and $WD_i$ represents a driver for the word line $W_i$. In the present invention, diodes $D_3$ and $D_4$, $D_5$ and $D_6$, ... are connected to the paired bit lines $B_{00}$ and $B_{01}$, $B_{10}$ and $B_{11}$, ... with the polarity shown in the drawings, and common connection ends of these diodes are connected to a constant current source $I_3$ through transistors $Q_7$, $Q_8$, ... . These diodes $D_3$ and $D_4$ or $D_5$ and $D_6$, ... form a current switch together with the constant current source $I_3$. Furthermore, the transistors $Q_7$, $Q_8$, ..., are controlled by column-selecting signals $Y_0$, $Y_1$, ... in the same way as the transistors $Q_3$ and $Q_4$, $Q_5$ and $Q_6$, ... .

When the diodes $D_3$ and $D_4$, $D_5$ and $D_6$, ... are connected to the corresponding pairs of the bit lines so that current switches are formed as described above, if the level of one bit line becomes higher than the level of the other bit line at the time of selection of the column, the diode connected to said one bit line is turned on to inhibit elevation of the potential. Accordingly, in this embodiment, the level of the bit line $B_{10}$ is abruptly lowered such as $B'_{10}$ indicated by the dotted line in Fig. 3C, thereby preventing the case where the transistor $Q_{1b}$ is turned off and the transistor $Q_{2b}$ is turned on in the selected cell $M_{11}$.

The diodes $D_3$ and $D_4$, $D_5$ and $D_6$, ... absorb current from the bit lines, in other words, dis- charge the stored charges in the bit lines, but this discharge is effected only when the corresponding column is selected by the transistors $Q_7$ and $Q_8$. The diodes are not actuated when the corresponding column is not selected. Accordingly, there is no problem of increase of the power consumption. Moreover, writing or reading is not disturbed at all. For example, in case of reading, if the memory cell $M_{i0}$ is selected by maintaining the word line $W_i$ and column-selecting votlage $Y_0$ at high levels and by turning on the transistors $Q_3$ and $Q_4$, and in the memory cell $M_{i0}$, the left transistor (for example $Q_{1b}$ in Fig. 2) is in the "on" state while the right transistor (for example $Q_{2b}$ in Fig. 2) is in the "off" state, a current $I_1$ flows through $WD_i$, $W_i$, $M_{i0}$, $B_{00}$ and $Q_3$ and a current $I_2$ flows through the reading transistor $Q_{11}$, bit line $B_{01}$ and transistor $Q_4$, but no current flows in the reading transistor $Q_{10}$ (ordinarily, $I_1$ is equal to $I_2$). A sense amplifier 2 shown in Fig. 4 detects the electric current flows in the transistors $Q_{10}$ or $Q_{11}$, and a reading output is thus produced. In addition to the above-mentioned currents $I_1$ and $I_2$, a current $I_3$ flows through $WD_i$, $M_{i0}$, $B_{00}$, $D_3$, and $Q_7$ in the present embodiment. However, the current-flowing state of the transistor $Q_{10}$ or $Q_{11}$ is not influenced by this current $I_3$. Writing is accomplished by selecting the memory cell, for example, $M_{i0}$, in the same manner as described above, lowering the potential of the bit line $B_{01}$ to turn on the right transistor of the cell and elevating the potential of the bit line $B_{00}$ to turn off the left transistor of the cell (changes of the potentials of these bit lines are performed according to the base potentials of the transistors $Q_{10}$ and $Q_{11}$). In the present embodiment, the current $I_3$ flow only through the transistor $Q_{10}$ when the level of one of the paired bit lines is lowered and, simultaneously, the level of the other bit line is elevated. Actuation and deenergization of the transistors and of the cell are not adversely effected by this current $I_3$.

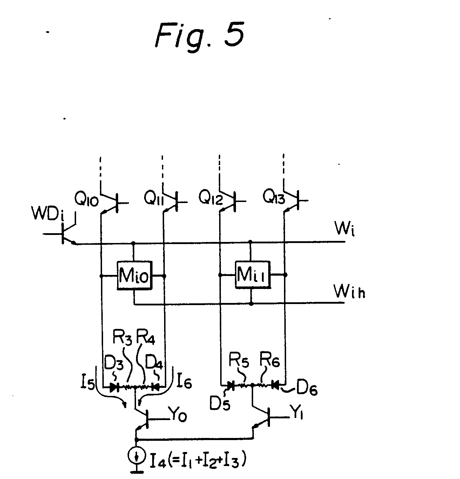

Fig. 5 illustrates another embodiment of the present invention, in which resistors $R_3$, $R_4$ are connected to the diodes, and a current $I_4$ is divided into currents $I_5$ and $I_6$, whereby the same effect as that attained in the embodiment shown in Fig. 4 is attained. Incidentally, the values of the resistors $R_3$ and $R_4$ are determined so that relations of $I_5=I_1+I_3$ and $I_6=I_2$ are established.

As will be apparent from the foregoing description, according to the present invention, occurrence of erroneous writing in a memory cell, which is likely to occur when reading is carried out by selecting the memory cell by changing word lines and column lines, can be prevented simply and assuredly.

**Claims**

1. A static semiconductor memory device including static memory cells ($M_{i0}$, $M_{i1}$) respectively connected to a pair of word lines ($W_0$, $W_1$) and a pair of bit lines ($B_{00}$, $B_{01}$), the static semiconductor memory device comprising a pair of unidirectional current elements (D₃, D₄) and a constant current source (I₃), each unidirectional current element being connected at one end so as to absorb electric current from a respective bit line of the pair of bit lines, characterised in that the other end of each unidirectional current element is connected to the constant current source via a switching means ($Q_7$), the switching means being switched ON by a column-selecting voltage ($Y_0$) only when the column-selecting voltage ($Y_0$) is at a level such that a respective column is selected.

2. A static semiconductor memory device according to claim 1, wherein each unidirectional current element is a diode and the switching means comprises a transistor ($Q_7$).

3. A static semiconductor memory device according to claim 2, wherein the switching means further comprises a pair of resistors ($R_3$, $R_4$, Figure 5) each connected between a respective one of the diodes and the said transistor.

4. A device according to claim 2 or 3, wherein the said transistor ($Q_7$) is switched together with column-selecting transistors ($Q_3$, $Q_4$) which are connected between the bit lines and current sources ($I_1$, $I_2$).

5. A device according to claim 4, wherein the connecting point of the pair of transistors is connected to the switching means.

**Patentansprüche**

1. Statische Halbleitervorrichtung mit statischen Speicherzellen ($M_{I0}$, $Mi_1$), die mit einem entsprechenden Paar von Wortleitungen ($W_0$, $W_1$) und einem Paar von Bitleitungen ($B_{00}$, $B_{01}$) verbunden sind, welche statische Halbleiterspeichervorrichtung ein Paar von in einer Richtung wirkenden Stromelementen ($D_3$, $D_4$) und eine Konstantstromquelle ($I_3$) umfaßt, von denen jedes in einer Richtung wirkende Stromelement an einem Ende so angeschlossen ist, daß es elektrischen Strom von einer entsprechenden Bitleitung des Paares von Bitleitungen absorbiert, dadurch gekennzeichnet, daß das andere Ende von jedem in einer Richtung wirkenden Stromelements über eine Schalteinrichtung ($Q_7$) mit der Konstantstromquelle verbunden ist, welches Schaltelement durch eine Spaltenauswahlspannung ($Y_0$) nur dann EIN-geschaltet wird, wenn die Spaltenauswahlspannung ($Y_0$) auf einem solchen Pegel ist, daß eine entsprechende Spalte ausgewählt wird.

2. Statische Halbleiterspeichervorrichtung nach Anspruch 1, bei der jedes in eine Richtung wirkende Stromelement eine Diode ist und die Schalteinrichtung einen Transistor ($Q_7$) umfaßt.

3. Statische Halbleiterspeichervorrichtung nach Anspruch 2, bei der die Schalteinrichtung ferner ein Paar von Widerständen ($R_3$, $R_4$, Figur 5) umfaßt, die jeweils zwischen einer entsprechenden der Dioden und dem genannten Transistor verbunden sind.

4. Vorrichtung nach Anspruch 2 oder 3, bei der der Transistor ($Q_7$) zusammen mit den Spaltenauswahltransistoren ($Q_3$, $Q_4$) geschaltet wird, welche zwischen den Bitleitungen und den Konstantstromquellen ($I_1$, $I_2$) angeschlossen sind.

5. Vorrichtung nach Anspruch 4, bei der der Verbindungspunkt des Paares von Transistoren mit der Schalteinrichtung verbunden ist.

**Revendications**

1. Dispositif de mémoire à semiconducteur statique incluant des cellules de mémoire statique ($M_{10}$, $M_{11}$) connectées respectivement à une paire de fils de mot ($W_0$, $W_1$) et à une paire de fils de bit ($B_{00}$, $B_{01}$), le dispositif de mémoire à semiconducteur statique comprenant une paire d'éléments à courant unidirectionnel ($D_3$, $D_4$) et une source de courant constant ($I_3$), chaque élément à courant unidirectionnel étant connecté par une extrémité de manière à absorber un courant électrique provenant d'un fil de bit respectif de la paire de fils de bit, caractérisé en ce que l'autre extrémité de chaque élément à courant unidirectionnel est connectée à la source de courant constant par l'intermédiaire d'un moyen de commutation ($Q_7$), le moyen de commutation étant rendu conducteur par une tension de sélection de colonne ($Y_0$) uniquement quand la tension de sélection de colonne ($Y_0$) est à un niveau tel qu'une colonne respective est sélectionnée.

2. Dispositif de mémoire à semiconducteur statique selon la revendication 1, dans lequel chaque élément à courant unidirectionnel est une diode et le moyen de commutation comprend un transistor ($Q_7$).

3. Dispositif de mémoire à semiconducteur statique selon la revendication 2, dans lequel le moyen de commutation comprend en outre une paire de résistances ($R_3$, $R_4$, Figure 5) connectées chacune entre une diode respective desdites diodes et ledit transistor.

4. Dispositif selon l'une quelconque des revendications 2 et 3, dans lequel le transistor ($Q_7$) est commuté ainsi que des transistors de sélection de colonne ($Q_3$, $Q_4$) qui sont connectés entre les fils de bit et les sources de courant ($I_1$, $I_2$).

5. Dispositif selon la revendication 4, dans lequel le point de connexion de la paire de transistors est connecté au moyen de commutation.

# 0 057 556

## Fig. 1

Fig. 2

Fig. 3A

Fig. 3B

Fig. 3C

COLUMN
SELECT

ROW
SELECT

2

# Fig. 4

# Fig. 5